# EUROPÄISCHE PATENTSCHRIFT

(11) **EP 1 466 398 B1**
(45) Veröffentlichungstag und Bekanntmachung des Hinweises auf die Patenterteilung: **22.11.2006**
(21) Anmeldenummer: 02796603.5
(22) Anmeldetag: 11.12.2002
(51) Int. Cl.: H02M 1/00

(54) **WECHSELRICHTER**
POWER INVERTER
CONVERTISSEUR

(30) Priorität: 13.12.2001 DE 10161178
(43) Veröffentlichungstag der Anmeldung: 13.10.2004
(73) Patentinhaber: Wobben, Aloys, 26607 Aurich (DE)
(72) Erfinder: Wobben, Aloys, 26607 Aurich (DE)
(74) Vertreter: Eisenführ, Speiser & Partner
(86) Internationale Anmeldenummer: PCT/EP2002/014031
(87) Internationale Veröffentlichungsnummer: WO 2003/050938

(56) Entgegenhaltungen:
- US-A- 5 172 310
- US-A- 5 579 217

## Beschreibung

Die vorliegende Erfindung betrifft einen Wechselrichter (Umrichter) zur Umwandlung eines Gleichstroms in einen Wechselstrom. Solche Wechselrichter sind seit langem bekannt und finden vielfältige Anwendung, u. a. in Windenergieanlagen. Dabei verwenden modeme Wechselrichter Halbleiter-Schaltelemente wie z. B. IGBT's, die in geeigneter Weise angesteuert werden, um den Wechselstrom zu erzeugen. Diese Halblejter-Schaltelemente sind zwar insgesamt relativ zuverlässig, jedoch ist ein Versagen nicht auszuschließen.

Aus der US 6,160,696 ist ein Wechselrichter mit den Merkmalen des Oberbegriffs des Anspruch 1 bekannt. Aus GB-A 2 214 731 ist ein Umrichter mit einem Gleichstromzwischenkreis bekannt.

Bei konventionell aufgebauten Wechselrichtern wird bei dem Ausfall eines solchen Halbleiter-Schaltelements dieses vor Ort ausgetauscht. Dabei können unbeabsichtigte und unerwünschte Verschmutzungen und/oder Beschädigungen und/oder Montagefehler auftreten, die unbemerkt bleiben und in kurzer Zeit zu einer (erneuten) Zerstörung des Halbleiter-Schaltelements führen. Die damit erneut erforderliche Instandsetzung erfordert einen Aufwand, der vermeidbar gewesen wäre.

Aufgabe der vorliegenden Erfindung ist es daher, einen Wechselrichter anzugeben, der diese Nachteile verringert bzw. vermeidet,

Die Aufgabe wird erfindungsgemäß mit einem Wechselrichter mit den Merkmalen nach Anspruch 1 gelöst. Vorteilhafte Weiterbildungen sind in den Unteransprüchen beschrieben.

Der Erfindung liegt die Erkenntnis zugrunde, dass eine Instandsetzung vor Ort naturgemäß fehleranfälllger ist als eine Instandsetzung in einer besonders dafür eingerichteten Werkstatt. Daher beschränkt sich die Instandsetzung vor Ort darauf, das defekte Modul zu identifizieren, auszubauen und durch ein einwandfreies Modul zu ersetzen. Neben der verringerten Fehleranfälligkeit des Instandsetzungsvorgangs an sich ist bei einer entsprechenden Ausgestaltung der Module ein Austausch schneller zu bewerkstelligen als eine Reparatur, so dass der Wechselrichter schneller wieder in Betrieb genommen werden kann.

In einer bevorzugten Ausführungsform der Erfindung orientiert sich die Modularisierung an der Funktion eines Moduls, so dass bei dem Auftreten einer Störung bereits aus der Störung auf ein bestimmtes Modul und wenigstens eine geringe Anzahl von Modulen geschlossen werden kann, die dann noch zu prüfen sind.

Gemäß der Erfindung nach Anspruch 1 umfasst der Wechselrichter weiterhin einen aus mehreren Kondensatoren gebildeten Zwischenspeicher, an welchen wenigstens ein Teil der Module angeschlossen ist. Wenn diese an den Zwischenspeicher angeschlossenen Module die Halbleiter-Schaltelement-Module sind, ist der Zwischenspeicher in der Lage, Schwankungen infolge der Schaltvorgänge der Halbleiter-Schaltelemente auszugleichen, und so einen stabilen Betrieb der Haltleiter-Schaltelemente zu ermöglichen.

Gemäß der Erfindung nach Anspruch 1 ist die Verbindung zwischen dem Zwischenspeicher und wenigstens einem Teil der Module kapazitiv. Durch diese kapazitive Ausgestaltung der Verbindung können die Einflüsse parasitärer Induktivitäten, die bei Verbindungsleitungen unvermeidlich sind, auf ein Minimum reduziert werden. Auf diese Weise lassen sich auch Betriebsstörungen vermeiden, die auf die Wirkung solcher Induktivitäten zurückführbar sind.

Um induktive Einflüsse weitestmöglich zu beseitigen, umfasst die kapazitive Verbindung in einem erfindungsgemäßen Wechselrichter nach Anspruch 1 wenigstens einen Plattenkondensator und die Module sind mechanisch mit den Platten dieses Plattenkondensators verbunden.

Gemäß der Erfindung nach Anspruch 1 bilden die Platten eines Plattenkondensators eine mechanische und elektrische Verbindung zwischen dem aus mehreren Kondensatoren gebildeten Zwischenspeicher und den angeschlossenen Modulen. Auf diese Weise lässt sich der Einfluss von Induktivitäten weitestmöglich verringern.

In einer besonders vorteilhaften Weiterbildung der Erfindung überschreitet der Abstand der Ausgangsklemmen der Halbleiter-Schaltelemente eines Moduls ein vorgegebenes Maß nicht. Damit weisen auch die daran angeschlossenen Leitungen einen entsprechenden Abstand auf. Auf diese Weise lassen sich diese benachbarten Leitungen durch einen gemeinsamen Messwandler führen und somit ist der Aufwand zur Erfassung des in den Leitungen fließenden Stromes begrenzt.

Vorteilhafte Weiterbildungen der Erfindung sind in den Unteransprüchen angegeben.

Im Folgenden wird eine Ausführungsform der Erfindung anhand der Figuren näher erläutert:
- Figur 1: eine vereinfachte Darstellung eines erfindungsgemäßen Wechselrichters;
- Figur 2: eine Auswahl von Modulen aus Figur 1;
- Figur 3: eine vergrößerte Einzelheit aus Figur 2;
- Figur 4: eine vereinfachte Darstellung eines Halbleiter-Moduls;
- Figur 5: eine Seitenansicht einer Kondensatorplatte;
- Figur 6: eine Ansicht einer weiteren Kondensatorplatte;
- Figur 7: eine Einzelheit der Kondensatorplatte; und
- Figur 8: eine alternative Ausführungsform zu Fig. 2.

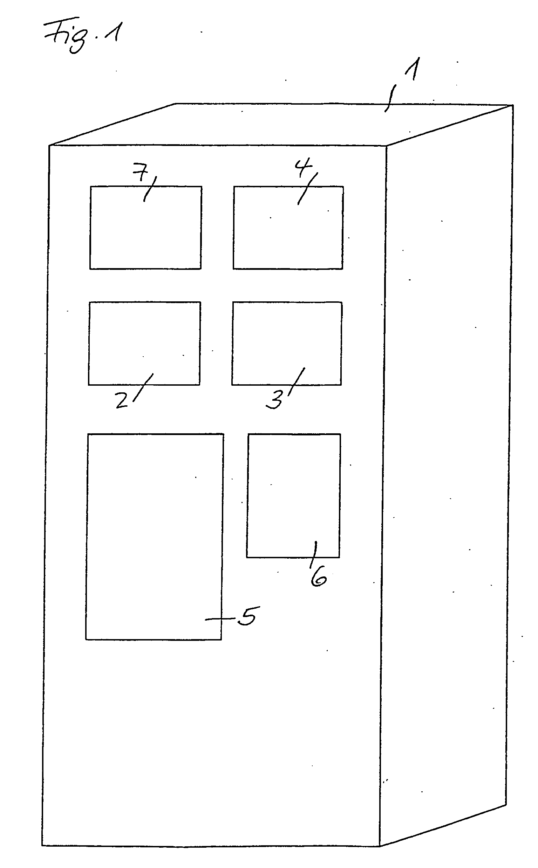

Figur 1 zeigt eine vereinfachte Darstellung eines erfindungsgemäßen Wechselrichters. In dieser Figur sind Komponenten wie Drosseln, Schütze, Sicherungseinrichtungen und ähnliches, aber auch Kabel, zur Verbesserung der Übersicht nicht dargestellt. Dieser Wechselrichter ist in einem Schrank 1 untergebracht und weist mehrere Module auf. Diese Module haben unterschiedliche Funktionen. So sind die Module 2, 3 und 4 Halbleiter-Module, welche aus einem Gleichstrom einen Wechselstrom erzeugen. Dabei ist für jede Phase ein eigenes Modul zu 2, 3 und 4 vorgesehen. Ein weiteres Modul 5 ist zur Steuerung sämtlicher Module des erfindungsgemäßen Wechselrichters vorgesehen. Ein Modul 6 ist ein Spannungs-Symmetrierer. Außerdem können weitere Module 7 vorgesehen sein. Diese können die Funktion eines Choppers, eines Hochsetzstellers, oder ähnliche übernehmen.

Diese Module 2, 3, 4, 5, 6, 7 sind in einen Schrank 1 eingebaut, der in besonderer Weise bereits für den Einbau von Modulen vorbereitet ist. Zwischen den Modulen 2, 3, 4, 5, 6, 7 verlaufen (nicht dargestellte) Kabelverbindungen, die bevorzugt über Steckverbindungen die einzelnen Module untereinander verbinden. Die Module 2, 3, 4, 5, 6, 7 selbst sind lösbar in dem Schrank 1 befestigt, z. B. mit Schrauben.

Zum Austausch eines Moduls 2, 3, 4, 5, 6, oder 7 sind daher lediglich die Kabel an diesem Modul abzuziehen und die Schraubverbindungen des Moduls zu lösen. So dann kann jedes einzelne der Module 2, 3, 4, 5, 6, 7 separat ausgetauscht werden. Im Fall einer Störung muss also der Servicetechniker lediglich ein entsprechendes Ersatzmodul an Stelle des als defekt erkannten Moduls einsetzen, und der Wechselrichter kann nach kurzer Instandsetzungszeit wieder in Betrieb genommen werden.

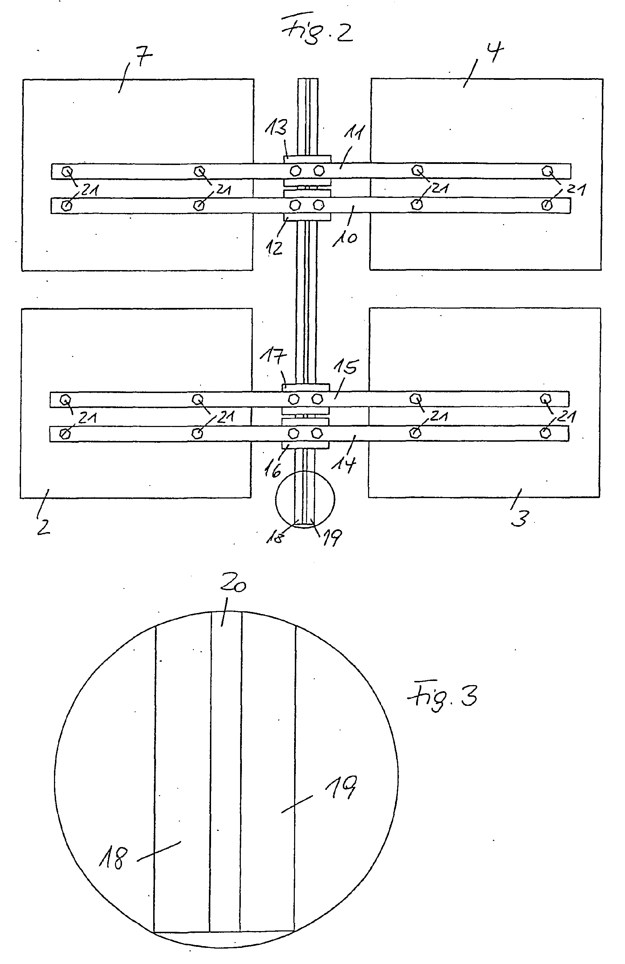

In Figur 2 ist insbesondere die Verbindung der Module 2, 3, 4 und 7 mit dem Gleichstromkreis des Wechselrichters gezeigt. In Verbindung mit Figur 1 wurde bereits erläutert, dass die Module 2, 3 und 4 Halbleitermodule sind, die jeweils für eine Phase einen Wechselstrom aus einem Gleichstrom erzeugen. Als Schaltelemente können z. B. Thyristoren oder IGTB's oder andere Halbleiter verwendet werden. Um diesen Modulen 2, 3, 4, 7 Gleichstrom zuzuführen, sind Anschlussplatten 12, 13, 16, 17 vorgesehen, mit welchen die Module 2, 3, 4, 7 verbunden sind. Diese Verbindung erfolgt über Schienen 10, 11, 14, 15, die einerseits an den Anschlussplatten 12, 13, 16, 17 und andererseits an den Modulen 2, 3, 4, 7 mit Schrauben 21 angebracht sind. Die Schienen 10, 11, 14, 15 sind ebenso wie die Anschlussplatten 12, 13, 16, 17 nach Potenzialen getrennt. In dem vorliegenden Ausführungsbeispiel können z. B. Platten 12 und 16 Anoden sein, so ein positives Potenzial aufweisen und die Platten 13 und 17 können Kathoden sein und entsprechend ein negatives Potenzial oder auch Masse-Potenzial aufweisen. Dementsprechend haben dann natürlich auch die Schienen 12 und 14 positives Potenzial und die Schienen 11 und 15 negatives oder Masse-Potenzial.

Durch die Verwendung von Schienen 10, 11, 14, 15 zum Zuführen elektrischer Energie zu den Modulen 2, 3, 4, 7 können entsprechend hohe Ströme fließen, da der Querschnitt der Schienen entsprechend groß ausgelegt werden kann. Zur Verbesserung der Handhabbarkeit können die Schienen 10, 11, 14, 15 geteilt sein, so dass jeweils eine separate Schiene 10, 11, 14, 15 von einer Anschlussplatte zu einem Modul 2, 3, 4, 7 verläuft.

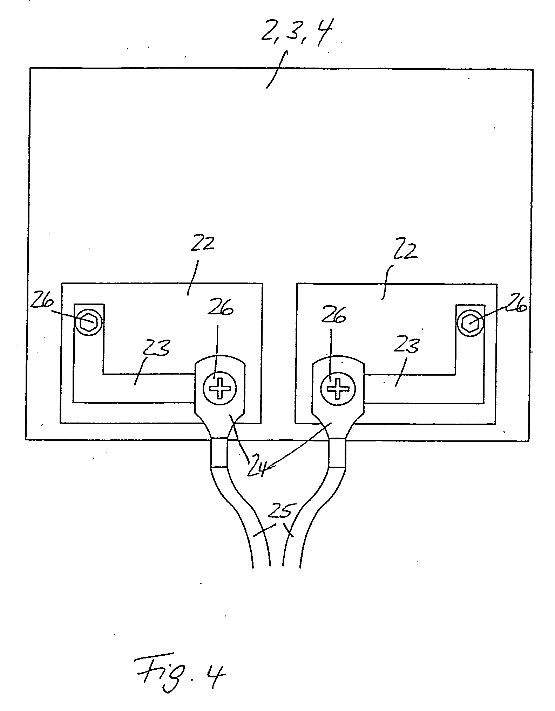

Wie in Figur 2 erkennbar ist, befinden sich hinter den Anschlussplatten 12, 13, 16, 17 parallel zueinander weitere Platten 18, 19. Die Anordnung und Wirkungsweise dieser Platten 18, 19 wird anhand von Figur 3 näher erläutert. Dabei zeigt Figur 3 eine vergrößerte Darstellung des in Figur 2 von einem Kreis umschlossenen Abschnitts.

In Figur 3 ist eine 3-lagige Struktur dargestellt. Diese 3-lagige Struktur ist gebildet aus zwei Kondensatorplatten 18, 19 und einem Dielektrikum 20. Entsprechend bildet dieser Aufbau einen Plattenkondensator. Dabei können die Platten 18, 19 dieses Kondensators z. B. aus Aluminium hergestellt sein und eine Dicke von mehreren Millimetern aufweisen. Das Dielektrikum 20 kann durch eine Kunststoff-Folie gebildet sein und eine Dicke von einigen zehntel Millimetern aufweisen. Bei diesem Aufbau ist eine der Platten 18,19 notwendigerweise die Anodenplatte, die andere Platte ist dann unvermeidlich die Kathodenplatte. Die Platten 18, 19 des Kondensators werden verwendet, um den Modulen 2, 3, 4, 7 Gleichstrom zuzuführen. Durch den Aufbau der Zuführung als Plattenkondensator ist diese Zuführung rein kapazitiv und der Einfluss unerwünschter Induktivitäten ist unterbunden. Wenn die Kondensatorplatte 18 die Kathodenplatte ist, sind die Anschlussplatten 13 und 17 mit dieser Kondensatorplatte 18 verbunden. Entsprechend sind die Anschlussplatten 12 und 16 mit der als Anodenplatte wirkenden Kondensatorplatte 19 verbunden.

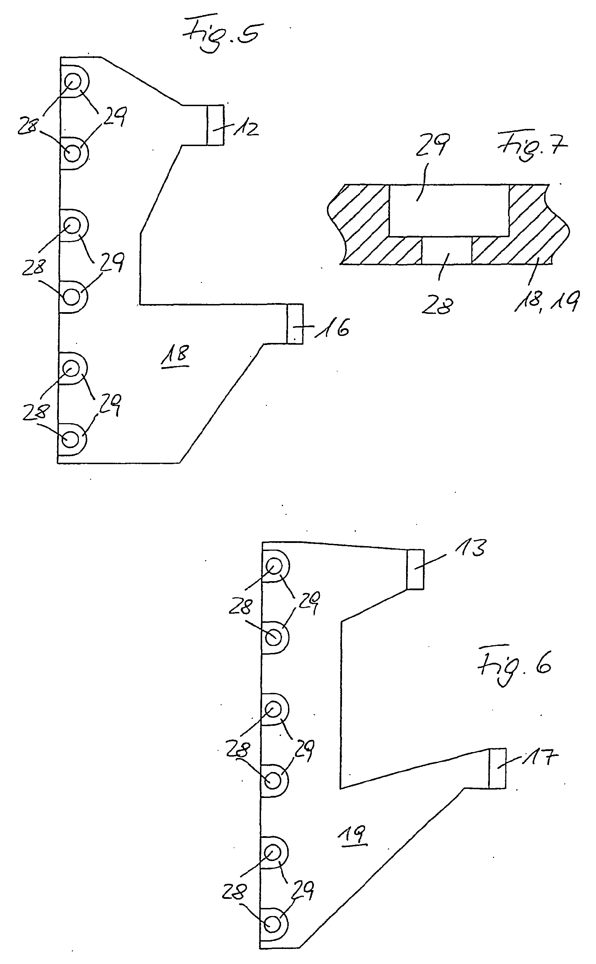

Figur 4 zeigt ein Halbleiter-Modul 2, 3, 4 in einer vereinfachten Darstellung, nämlich mit den Halbleiter-Schaltelementen 22. Diese Halbleiter-Schaltelemente 22, für die z. B. als IGTB's verwendet werden, werden in geeigneter und im Stand der Technik bekannter Weise angesteuert, um einen gewünschten Wechselstrom zu erzeugen, der über Kabel 25 abgeleitet wird. Die Wirkungsweise eines solchen Halbleitermoduls kann z. B. aus der Patentschrift DE 197 48 479 C1 entnommen werden.

Um den Abstand zwischen mit den Kabelschuhen 24 bestückten Kabeln 25 und damit natürlich auch zwischen den Kabeln 25 auf ein vorgegebenes Maß zu begrenzen, können Halbleiter-Schalterelemente 22 mit entsprechend angeordneten Anschlüssen vorgesehen sein. Altemativ sind von den Ausgangsanschlüssen der Halbleitermodule 22 zu den Kabelschuhen 24 Schienen 23 vorgesehen, die den Ausgangsstrom des Halbleiterelementes 22 zu dem entsprechenden Kabel 25 weiterleiten. Diese Schienen 23 sind mit Schrauben 26, die hier als Innensechskantschrauben dargestellt sind, an dem Ausgangsanschluss des Halbleitermoduls 22 befestigt und die Kabel 25 sind mittels Kabelschuhen 24 und Schrauben 26, die als Kreuzschlitzschrauben dargestellt sind, wiederum an den Schienen 23 befestigt. Durch diese Anordnung ist es möglich, die beiden Kabel 25 z. B. gemeinsam durch einen Messwertaufnehmer wie einen Ferritring eines Stromwandlers zu führen, um den Stromfluss in den Kabeln 25 zu überwachen.

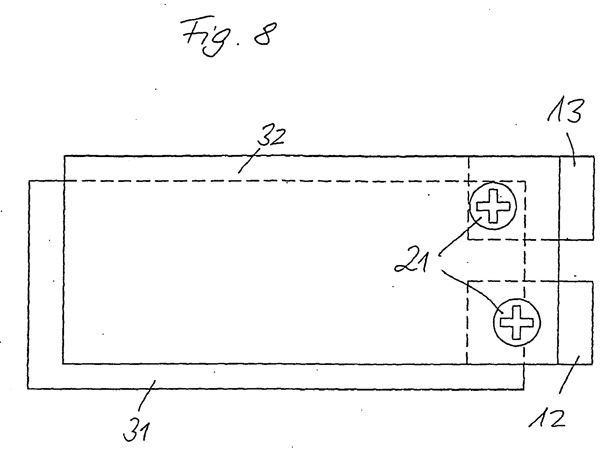

Erfindungsgemäß verfügt der Wechselrichter über einen Zwischenspeicher, der aus einer Mehrzahl von Kondensatoren gebildet ist. Dieser Zwischenspeicher hat u. a. die Aufgabe, die an den Halbleitermodulen anliegende Gleichspannung zu glätten und Spannungsschwankungen infolge der Schaltvorgänge der Halbleiter-Schaltelemente 22 auszugleichen. Dazu ist dieser Zwischenspeicher (nicht dargestellt) über den Plattenkondensator 18, 19, 20 mit den Modulen verbunden. Die Platten 18, 19 des Plattenkondensators sind in den Figuren 5 und 6 dargestellt. Dabei zeigt Figur 5 die Anodenplatte und Figur 6 zeigt die Kathodenplatte. Diese Platten 18, 19 weisen Bohrungen 28 und diese Bohrungen umfassende Ausnehmungen 29 auf. Dies ist detailliert am Beispiel einer Bohrung/Ausnehmung in Figur 7 im Querschnitt dargestellt.

Durch diese Anordnung ist es einerseits möglich, die den Zwischenspeicher bildenden, jedoch nicht dargestellten Kondensatoren durch Verschraubung mit den Platten 18, 19 zu verbinden, so dass bei Bedarf auch einzelne Kondensatoren ausgetauscht werden können, und durch die versenkte Anbringung des Schraubenkopfes in der Ausnehmung 29 die Platten nur um den Abstand des Dielektrikums (Bezugszeichen 20 in Fig. 3) voneinander getrennt nebeneinander anzuordnen. Ein Vergleich der in den Figuren 5 und 6 dargestellten Platten zeigt bereits, dass die Anschlussplatten 12, 13, 16, 17 für die Anschluss-Schienen in der Höhe zueinander versetzt sind, so dass sich die bereits in Figur 2 dargestellte Staffelung ergibt.

Figur 8 zeigt eine alternative Anordnung zu den in Figur 2 gezeigten Anschluss-Schienen 10, 11, 14, 15. Dazu werden die Schienen derart verbreitert, dass sie beide Anschlussplatten 12, 13 überdecken. Diese in dieser Figur ebenfalls plattenförmig dargestellten Schienen sind hier mit den Bezugszeichen 31 und 32 bezeichnet. Um zu verdeutlichen, dass diese übereinander liegen, sind sie gegeneinander versetzt dargestellt. In situ liegen sie im Wesentlichen deckungsgleich übereinander.

Dabei ist eine der Platten mit der Anode 12 und die andere mit der Kathode 13 verbunden. Durch ein zwischen den Platten 31, 32 eingefügtes, jedoch in der Figur nicht dargestelltes Dielektrikum bilden auch diese Platten 31, 32 einen Kondensator. Gemäß der Darstellung in dieser Figur ist die Platte 32 die Anodenplatte und die Platte 31 ist die Kathodenplatte. Natürlich sind diese Platten wiederum entsprechend mit den ebenfalls in dieser Figur nicht dargestellten Halbleitermodulen verbunden, um diesen den erforderlichen Gleichstrom zuzuführen. Da somit auch die Verbindung von den Anschlussplatten 12, 13 zu den Halbleitermodulen über einen Plattenkondensator erfolgt, ist auch auf diesem Abschnitt des elektrischen Anschlusses ein induktiver Einfluss unterbunden.

Damit ergibt sich eine kapazitive Verbindung von dem Zwischenspeicher bis zu den Eingangsklemmen der Halbleitermodule.

## Patentansprüche

1. Wechselrichter mit
wenigstens einen teilweise modularen Aufbau, mit lösbar eingebauten Modulen (2, 3, 4), an den Modulen (2, 3, 4) lösbar angebrachten Verbindungen, wobei ein Modul jeweils ein Halbleitermodul ist, welches jeweils für eine. Phase einen Wechselstrom aus einem Gleichstrom erzeugt, und einem aus mehreren Kondensatoren gebildeten Zwischenspeicher, **dadurch gekennzeichnet, daß**
wenigstens ein Teil der Module (2, 3, 4, 5, 6, 7) über eine kapazitive Verbindung an den Zwischenspeicher angeschlossen ist,
die kapazitive Verbindung wenigstens einen Plattenkondensator (18, 19, 20, 31, 32) umfasst, und die Module (2, 3, 4, 5, 6, 7) mechanisch und elektrisch mit den Platten der Plattenkondensatoren (18, 19; 31, 32) verbunden sind.

2. Wechselrichter nach Anspruch 1,
**gekennzeichnet durch** eine an der Funktion eines Moduls (2, 3, 4, 5, 6, 7) orientierte Modularisierung.

3. Wechselrichter nach Anspruch 2,
**gekennzeichnet durch**
lösbar mit den Kondensatorplatten (18, 19; 31, 32) verbundene Kondensatoren.

4. Wechselrichter nach einem der vorstehenden Ansprüche,
**dadurch gekennzeichnet, dass** der Abstand der Ausgangsklemmen der Halbleiter-Schaltelemente (22) eines Moduls (2, 3, 4, 5, 6, 7) ein vorgegebenes Maß nicht überschreitet.

5. Windenergleanlage,
**gekennzeichnet durch** wenigstens einen Wechselrichter nach einem der vorstehenden Ansprüche.

## Claims

1. Inverter having at least a partly modular structure, with releasably installed modules (2, 3, 4), connections releasably mounted on the modules (2, 3, 4), wherein a module is in each case a semiconductor module that in each case generates for a phase an alternating current from a direct current, and with an intermediate store formed by a plurality of capacitors, **characterised in that**
at least some of the modules (2, 3, 4, 5, 6, 7) are connected to the intermediate store via a capacitive connection,
the capacitive connection includes at least one plate capacitor (18, 19, 20, 31, 32), and the modules (2, 3, 4, 5, 6, 7) are mechanically and electrically connected to the plates of the plate capacitors (18, 19; 31, 32).

2. Inverter according to claim 1,
**characterised by** a modularisation oriented to the function of a module (2, 3, 4, 5, 6, 7).

3. Inverter according to claim 2,
**characterised by** capacitors releasably connected to the capacitor plates (18, 19; 31, 32).

4. Inverter according to any one of the preceding claims,
**characterised in that** the spacing of the output terminals of the semiconductor switching elements (22) of a module (2, 3, 4, 5, 6, 7) does not exceed a predefined dimension.

5. Wind power installation,
**characterised by** at least one inverter according to any one of the preceding claims.

## Revendications

1. Convertisseur avec au moins une structure partiellement modulaire, avec des modules (2, 3, 4) montés de manière amovible, avec des liaisons disposées de manière amovible sur les modules (2, 3, 4), un module étant respectivement un module à semi-conducteurs qui génère respectivement pour une phase un courant alternatif à partir d'un courant continu, et avec une mémoire tampon formée par plusieurs condensateurs, **caractérisé**
**en ce qu'**au moins une partie des modules (2, 3, 4, 5, 6, 7) est raccordée à la mémoire tampon par l'intermédiaire d'une liaison capacitive,
**en ce que** la liaison capacitive comprend au moins un condensateur à lames (18, 19, 20, 31, 32) et en ce que les modules (2, 3, 4, 5, 6, 7) sont reliés mécaniquement et électriquement avec les lames des condensateurs à lames (18, 19 ; 31, 32).

2. Convertisseur selon la revendication 1, **caractérisé par** une modularisation ciblée sur la fonction d'un module (2, 3, 4, 5, 6, 7).

3. Convertisseur selon la revendication 2, **caractérisé par** des condensateurs reliés de manière amovible avec les lames des condensateurs (18, 19 ; 31, 32).

4. Convertisseur selon l'une quelconque des revendications précédentes,
**caractérisé en ce que** l'espacement des bornes de sortie des éléments de commutation à semi-conducteurs (22) d'un module (2, 3, 4, 5, 6, 7) ne dépasse pas une côte prédéfinie.

5. Eolienne,
**caractérisée par** au moins un convertisseur selon l'une quelconque des revendications précédentes.
